# EUROPEAN PATENT APPLICATION

(11) **EP 4 624 960 A1**
(43) Date of publication of application: **01.10.2025**
(21) Application number: 23914984.2
(22) Date of filing: 20.12.2023
(51) Int. Cl.: G01R 31/392, G01R 31/367, G01R 31/382, G01R 31/385, G01R 31/396, H02J 7/00, G06N 20/00

(54) **BATTERY LIFESPAN ESTIMATION DEVICE AND METHOD**

(30) Priority: 02.01.2023 KR 20230000453
(71) Applicant: LG Energy Solution, Ltd., Seoul 07335 (KR)
(72) Inventor: PARK, Ki Bum, Daejeon 34122 (KR); YOU, Tae Gyeong, Daejeon 34122 (KR)
(74) Representative: Goddar, Heinz J.
(86) International application number: PCT/KR2023/021172
(87) International publication number: WO 2024/147524

(57) **Abstract**

A battery life estimation apparatus includes a charging/discharging unit configured to charge/discharge a battery and a controller configured to calculate a partial accumulative capacity corresponding to a partial voltage period defined as a period from a first voltage to a second voltage by charging/discharging the battery in the partial voltage period, and estimate a life corresponding to an entire voltage period of the battery by inputting the first voltage, the second voltage, and the partial accumulative capacity to an estimation model trained based on machine learning.

## Description

### [TECHNICAL FIELD]

### CROSS-REFERENCE TO RELATED APPLICATION

This application claims priority to and the benefit of Korean Patent Application No. 10-2023-0000453 filed in the Korean Intellectual Property Office on January 2, 2023, the entire content of which is incorporated herein by reference.

### TECHNICAL FIELD

Embodiments disclosed herein relate to a battery life estimation apparatus and method.

### [BACKGROUND ART]

Recently, devices for stably supplying and managing power, such as portable devices like smartphones or laptop computers, electric vehicles or electric kickboards, transport means like electric two wheel vehicles, and energy storage systems (ESS) have been widely used, interests in batteries are increasing and development of the batteries is becoming more active.

With the spread of devices using batteries, the size of a battery recycling market, etc., as well as a general battery market is increasing. For battery recycling, a technique for measuring a life of a battery is required to determine whether the battery is recyclable. However, a method for measuring a life of a battery by charging/discharging the whole capacity of the battery is inefficient in terms of measurement time and power.

### [DISCLOSURE]

### [TECHNICAL PROBLEM]

Embodiments disclosed herein aim to provide an apparatus and method for efficiently estimating a life of a battery.

Technical problems of the embodiments disclosed herein are not limited to the above-described technical problems, and other unmentioned technical problems would be clearly understood by those skilled in the art in the technical field to which the present disclosure pertains from the following description.

### [TECHNICAL SOLUTION]

A battery life estimation apparatus according to an embodiment disclosed herein includes a charging/discharging unit configured to charge/discharge a battery and a controller configured to calculate a partial accumulative capacity corresponding to a partial voltage period defined as a period from a first voltage to a second voltage by charging/discharging the battery in the partial voltage period, and estimate a life corresponding to an entire voltage period of the battery by inputting the first voltage, the second voltage, and the partial accumulative capacity to an estimation model trained based on machine learning.

According to an embodiment, the entire voltage period may be defined as a period from a third voltage defined as a voltage corresponding to a point at which a state of charge (SOC) of the battery is 0 % to a fourth voltage defined as a voltage corresponding to a point at which the SOC of the battery is 100 %.

According to an embodiment, a rate of the partial voltage period with respect to the entire voltage period may be at least 50 % but less than 100 %.

According to an embodiment, the controller may be further configured to control the charging/discharging unit to charge/discharge the battery at a first charging/discharging rate in the partial voltage period.

According to an embodiment, the first charging/discharging rate may be 1C-rate (C).

According to an embodiment, the controller may be further configured to train a first regression model and a second regression model, which is different from the first regression model, based on machine learning, and select, as the estimation model, a model having a less mean absolute error (MAE) between the first regression model and the second regression model.

According to an embodiment, the controller may be further configured to obtain a measurement life corresponding to the entire voltage period of the battery by charging/discharging the battery in the entire voltage period, obtain an estimation life corresponding to the entire voltage period of the battery by inputting the first voltage, the second voltage, and the partial accumulative capacity to the first regression model, and obtain an MAE of the first regression model based on the measurement life and the estimation life.

According to an embodiment, the estimation model may include a random forest model.

According to an embodiment, the controller may be further configured to train each of the first regression model and the second regression model to output a life corresponding to the entire voltage period, when the first voltage, the second voltage, and the partial accumulative capacity are input.

According to an embodiment, the battery life estimation apparatus may further include a memory storing the first voltage, the second voltage, the partial accumulative capacity, and the estimation model.

A battery life estimation method according to an embodiment disclosed herein includes calculating a partial accumulative capacity corresponding to a partial voltage period defined as a period from a first voltage to a second voltage by charging/discharging a battery in the partial voltage period, generating an estimation model trained based on machine learning, and estimating a life corresponding to an entire voltage period of the battery by inputting the first voltage, the second voltage, and the partial accumulative capacity to the estimation model.

According to an embodiment, the generating of the estimation model may include training a first regression model and a second regression model, which is different from the first regression model, based on machine learning, and select, as the estimation model, a model having a less mean absolute error (MAE) between the first regression model and the second regression model.

According to an embodiment, the generating of the estimation model may include obtaining a measurement life corresponding to the entire voltage period of the battery by charging/discharging the battery in the entire voltage period, obtaining an estimation life corresponding to the entire voltage period of the battery by inputting the first voltage, the second voltage, and the partial accumulative capacity to the first regression model, and obtaining an MAE of the first regression model based on the measurement life and the estimation life.

According to an embodiment, the estimation model may include a random forest model.

According to an embodiment, the generating of the estimation model may include training each of the first regression model and the second regression model to output a life corresponding to the entire voltage period, when the first voltage, the second voltage, and the partial accumulative capacity are input.

According to an embodiment, the calculating of the partial accumulative capacity may include charging/discharging the battery at a first charging/discharging rate in a period corresponding to the partial voltage period.

According to an embodiment, the first charging/discharging rate may be 1C-rate (C).

Detailed matters of other embodiments are included in a detailed description and drawings.

### [ADVANTAGEOUS EFFECTS]

A battery life estimation apparatus and method according to embodiments disclosed herein may estimate a life of a battery merely with partial charging/discharging of the battery.

The battery life estimation apparatus and method according to embodiments disclosed herein may reduce a time and a cost of battery life measurement.

### [DESCRIPTION OF DRAWINGS]

FIG. 1 illustrates a battery pack according to an embodiment disclosed herein.
FIG. 2 is a block diagram of a battery life estimation apparatus according to an embodiment disclosed herein.
FIG. 3 is a graph showing a partial voltage period according to an embodiment disclosed herein.
FIG. 4 is a schematic diagram showing a case in which a battery life estimation apparatus according to an embodiment disclosed herein uses a random forest as an estimation model.
FIG. 5 is a schematic diagram showing a case in which a battery life estimation apparatus according to an embodiment disclosed herein uses XGBoost as an estimation model.
FIG. 6 is a flowchart of a battery life estimation method according to an embodiment disclosed herein.
FIG. 7 illustrates a computing system that executes a battery life estimation method, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

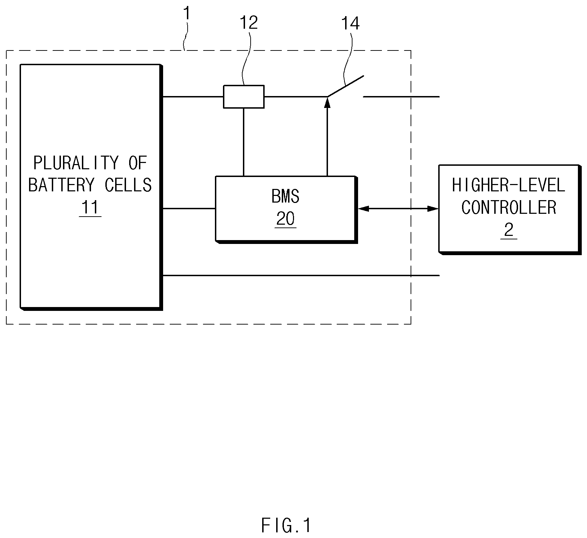

FIG. 1 illustrates a battery pack according to an embodiment disclosed herein.

Referring to FIG. 1, a battery control system including a battery pack 1 and a higher-level controller 2 included in a higher-level system according to an embodiment disclosed herein is schematically shown.

As shown in FIG. 1, the battery pack 1 may include one or more battery cells 11, a switching unit 14 serially connected to a first terminal side and/or a second terminal side of the battery cells 11 to control a charging/discharging current flow of the battery cells 11, and a battery management system 20 for management to prevent over-charging and over-discharging by monitoring a voltage, a current, a temperature, etc., of the battery pack 1.

In this case, the battery pack 1 may include the battery cells 11, the sensor 12, the switching unit 14, and the battery management system 20 provided in plural. For example, the first terminal may be a positive (+) terminal of the battery cells 11, and the second terminal may be a negative (-) terminal.

The battery cells 11 may include a plurality of battery cells. The plurality of battery cells may form one battery pack 1, but the present disclosure is not limited thereto. According to an embodiment, the battery cells 11 may be substantially one battery pack 1. According to another embodiment, the battery cells 11 may be a group of the plurality of battery cells without forming a pack. The plurality of battery cells included in the battery cells 11 may be connected to each other so as to be driven in one unit.

Herein, as the switching unit 14 which is an element for controlling a current flow for charging or discharging of the plurality of battery cells 11, for example, at least one relay, magnetic contactor, etc., may be used according to specifications of the battery pack 1.

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery cells 11 to monitor the state of each battery cell 11.

The higher-level controller 2 may transmit a control signal regarding the battery cells 11 to the battery management system 20. Thus, the battery management system 20 may also be controlled in terms of an operation thereof based on a signal applied from the higher-level controller 2.

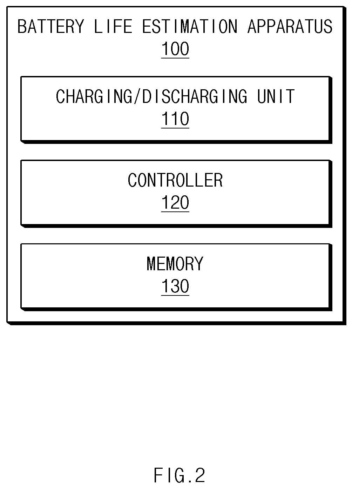

According to an embodiment, the battery management system 20 may include a battery life estimation apparatus 100 of FIG. 2. According to another embodiment, the battery management system 20 may be different from the battery life estimation apparatus 100 of FIG. 2. That is, the battery life estimation apparatus 100 of FIG. 2 may be included in the battery pack 1 and may be configured as another device outside the battery pack 1. Hereinbelow, for convenience of description, it is assumed that the battery life estimation apparatus 100 is included in another device outside the battery pack 1.

The battery life estimation apparatus 100 may estimate a capacity of the battery cells 11. To this end, the battery life estimation apparatus 100 may be connected to the battery cells 11.

According to an embodiment, the battery life estimation apparatus 100 may charge/discharge the battery cells 11. The battery life estimation apparatus 100 may charge/discharge the battery cells 11 in a partial voltage period. Herein, the entire voltage period may be defined as a period from a third voltage defined as a voltage corresponding to a point at which a state of charge (SOC) of the battery cells 11 is 0 % to a fourth voltage defined as a voltage corresponding to a point at which the SOC of the battery is 100 %. The partial voltage period may be defined as a partial period of the entire voltage period of the battery cells 11. That is, the partial voltage period may be defined as a period from a first voltage to a second voltage, and the period from the first voltage to the second voltage may be included in the period from the third voltage to the fourth voltage. For example, the partial voltage period may be defined as a period from the first voltage corresponding to a point at which the SOC of the battery cells 11 is 30 to the second voltage corresponding to a point at which the SOC of the battery is 80. A rate of the partial voltage period with respect to the entire voltage period may be at least 50 % but less than 100%.

The battery life estimation apparatus 100 may estimate the life of the battery cells 11 by charging/discharging the battery cells 11 in the partial voltage period. This will be described in detail later.

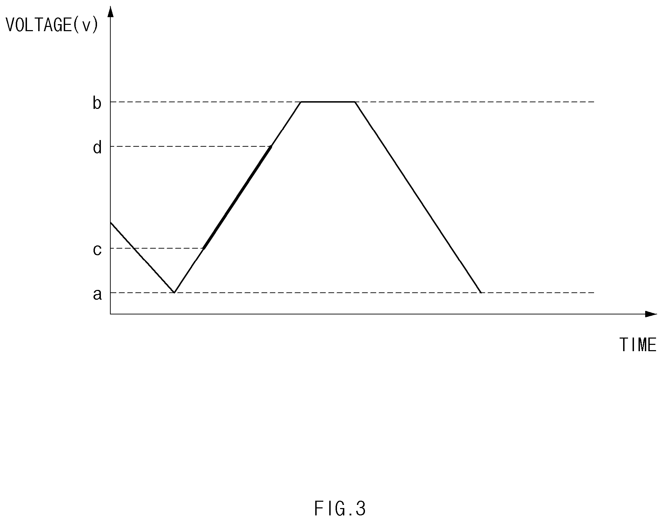

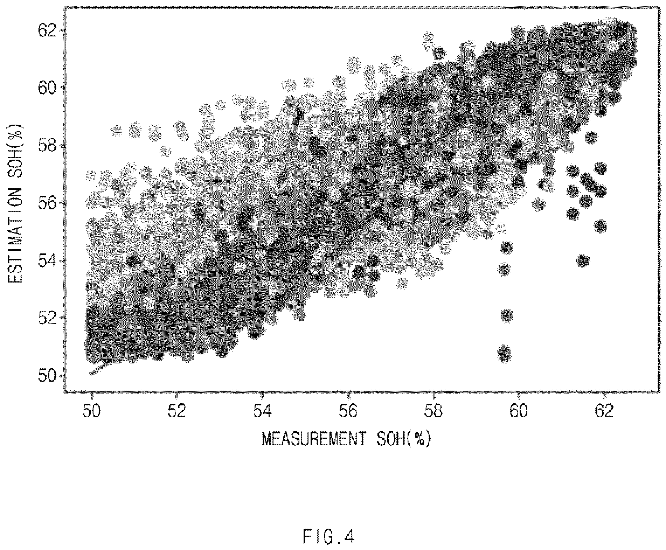

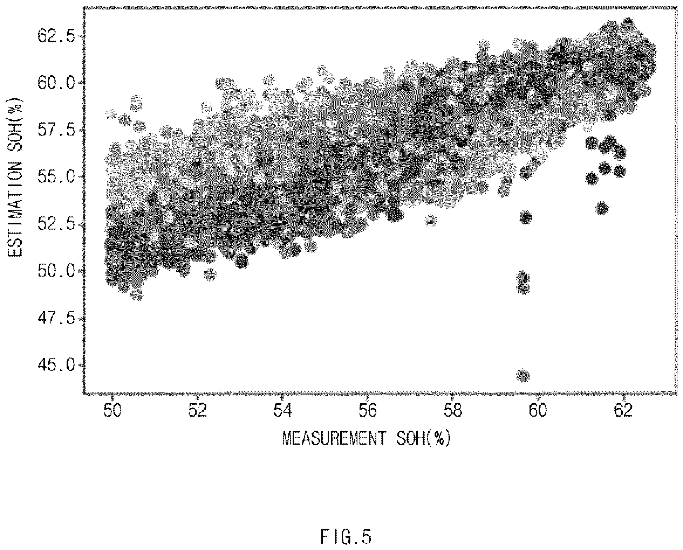

FIG. 2 is a block diagram of a battery life estimation apparatus according to an embodiment disclosed herein. FIG. 3 is a graph showing a partial voltage period according to an embodiment disclosed herein. FIG. 4 is a schematic diagram showing a case in which a battery life estimation apparatus according to an embodiment disclosed herein uses a random forest as an estimation model. FIG. 5 is a schematic diagram showing a case in which a battery life estimation apparatus according to an embodiment disclosed herein uses XGBoost as an estimation model.

First, referring to FIG. 2, the battery life estimation apparatus 100 may include a charging/discharging unit 110, a controller 120, and a memory 130.

The charging/discharging unit 110 may charge/discharge the battery cells 11. According to an embodiment, the charging/discharging unit 110 may charge/discharge the battery cells 11 by supplying current to the battery cells 11 in a partial voltage period. Herein, a charging/discharging speed of the charging/discharging unit 110 may have various values. For example, the charging/discharging unit 110 may charge/discharge the battery cells 11 by supplying current to the battery cells 11 at a first charging/discharging rate.

The controller 120 may control the charging/discharging unit 110. According to an embodiment, the controller 120 may control the charging/discharging unit 110 to control a start point and an end point of charge/discharge, and a charging/discharging rate.

Referring to FIG. 3, the controller 120 may control the charging/discharging unit 110 to supply current to the battery cells 11, thus charging the battery cells 11, or to receive the current from the battery cells 11, thus discharging the battery cells 11. Accordingly, the voltage of the battery cells 11 may rise or drop.

According to an embodiment, the entire voltage period of the battery cells 11 may be defined as a period from a point at which the voltage of the battery cells 11 is a V to a point at which the voltage of the battery cells 11 is b V. According to an embodiment, the point at which the voltage of the battery cell is a V may correspond to a point at which the SOC of the battery cells 11 is 0 %, and the point at which the voltage of the battery cell is b V may correspond to a point at which the SOC of the battery cells 11 is 100 %. The partial voltage period of the battery cells 11 may be defined as a period from a point at which the voltage of the battery cells 11 is c V to a point at which the voltage of the battery cells 11 is d V. Herein, c may be greater than a, and d may be less than b. That is, the partial voltage period may be included in the entire voltage period.

The controller 120 may calculate a partial accumulative capacity between the first voltage and the second voltage by charging/discharging the battery cells 11 in the partial voltage period. That is, the first voltage may be defined as a voltage of a battery cell at a start point of the partial period. Thus, in FIG. 3, the first voltage may be c V. The second voltage may be defined as a voltage of a battery cell at an end point of the partial voltage period. Thus, in FIG. 3, the second voltage may be d V. The partial accumulative capacity may be defined as a total amount of current supplied to or from the battery cells 11 by the controller 120 controlling the charging/discharging unit 110. That is, the partial accumulative capacity may be a product of a current flowing between the charging/discharging unit 110 and the battery cells 11 in the partial voltage period and a time required for the controller 120 to change the voltage of the battery cells 11 from the first voltage to the second voltage. Thus, the unit of the partial accumulative capacity may be an ampere hour (Ah).

According to an embodiment, the controller 120 may adjust a range of the partial voltage period to improve the accuracy of life estimation. For example, the controller 120 may set the partial voltage period to at least 50 % but less than 100 % of the entire voltage period.

Referring back to FIG. 2, the controller 120 may adjust the charging/discharging speed of the charging/discharging unit 110. That is, the controller 120 may adjust the charging/discharging rate of the charging/discharging unit 110. According to an embodiment, the controller 120 may charge/discharge the battery cells 11 at the first charging/discharging rate. For example, the first charging/discharging rate may be 1 C-rate (C). As the controller 120 charges/discharges the battery cells 11 at a charging/discharging rate of 1 C, a charging/discharging time of the battery cells 11 may be reduced when compared to charging/discharging of the battery cells 11 at a charging/discharging rate of 0.3 C.

The controller 120 may generate an estimation model. The controller 120 may generate an estimation model trained based on machine learning. The controller 120 may train a plurality of regression models based on machine learning and select, as the estimation model, one having the best performance from among the plurality of regression models. That is, the estimation model may be one of the plurality of regression models.

The controller 120 may train each regression model based on the first voltage, the second voltage, and the partial accumulative capacity. That is, the controller 120 may supervised-train each regression model based on the first voltage, the second voltage, and the partial accumulative capacity, which are input values of the regression model, and the life of the battery cells 11, obtained by charging/discharging the battery cells 11 in the entire voltage period. Herein, the life of the battery cells 11 may be a state of health (SOH). Thus, by supervised-training the regression model, the controller 120 may configure the regression model to output the life of the battery cells 11 if the first voltage, the second voltage, and the partial accumulative capacity are input to the regression model. Herein, the plurality of regression models may include various models such as a random forest, XGBoost, etc.

Referring to FIGS. 4 and 5, the controller 120 may compare the life estimated using the regression model with the life obtained by charging/discharging the battery cells 11. Herein, the life of the battery cells 11 estimated using the regression model by the controller 120 may be defined as an estimation life. The life of the battery cells, obtained by charging/discharging the battery cells in the entire voltage period, may be defined as a measurement life. That is, the controller 120 may compare the estimation life with the measurement life for each regression model.

For comparison between the estimation life and the measurement life, the controller 120 may estimate the estimation life of the plurality of battery cells 11 using the regression model and measure the measurement life of the plurality of battery cells 11.

The controller 120 may measure the estimation life. The controller 120 may control the charging/discharging unit 110 to charge/discharge the battery cells 11 at a second charging/discharging rate in the entire voltage period of the battery cells 11. According to an embodiment, the second charging/discharging rate may be different from the first charging/discharging rate. For example, the second charging/discharging rate may be 0.3 C-rate (C).

The controller 120 may generate a pair of an estimation life and a measurement life for each of the plurality of battery cells 11. In this way, the controller 120 may compare the estimation life with the measurement life for each of the plurality of battery cells 11.

The controller 120 may generate a graph of an estimation life and a measurement life for each of the plurality of regression models. Herein, the plurality of regression models may include a first regression model and a second regression model. According to an embodiment, the first regression model may be a random forest, and the second regression model may be XGBoost.

According to an embodiment, the controller 120 may generate a graph having a measurement life as an X axis and an estimation life as a Y axis for the first regression model. That is, the controller 120 may generate a graph having a measurement SOH as an X axis and an estimation SOH as a Y axis for the first regression model. The controller 120 may indicate in the graph, a pair of the estimation life estimated using the first regression model and the measurement life measured by the controller 120. That is, the pair of the measurement life and the estimation life, generated by the controller 120, may be shown as one dot on the graph of FIG. 4. The controller 120 may perform the same process for a sufficient number of battery cells 11 to indicate a sufficient number of pair of measurement lives and estimation lives in the graph.

According to an embodiment, the controller 120 may generate a graph having a measurement life as an X axis and an estimation life as a Y axis for the second regression model. The controller 120 may indicate in the graph, a pair of the estimation life estimated using the second regression model and the measurement life measured by the controller 120. That is, the pair of the measurement life and the estimation life, generated by the controller 120, may be shown as one dot on the graph of FIG. 5. The controller 120 may perform the same process for a sufficient number of battery cells 11 to indicate a sufficient number of pair of measurement lives and estimation lives in the graph.

The controller 120 may evaluate the performance of each regression model. According to an embodiment, the controller 120 may evaluate the regression model by using an evaluation indicator such as a mean absolute error (MAE), a mean squared error (MSE), or a root mean squared error (RMSE). In this way, the controller 120 may select a regression model having a superior evaluation indicator as the estimation model based on such performance evaluation. That is, the controller 120 may evaluate which one of the first regression model and the second regression model has superior performance based on a performance evaluation indicator and select the model having the superior performance as the estimation model.

According to an embodiment, the controller 120 may be calculate an MAE of a random forest model based on the graph of FIG. 4. The controller 120 may calculate an MAE of XGBoost based on the graph of FIG. 5. In this case, the MAE of the random forest, calculated by the controller 120, may be a value less than the MAE of XGBoost. A less value of the MAE may be closer to an ideal state, such that the controller 120 may select the random forest as an estimation model. While it is described that the controller 120 selects the estimation model based on the MAE, the present disclosure is not limited thereto. According to another embodiment, the controller 120 may select the estimation model based on the MSE or the RMSE.

The controller 120 may estimate the life. According to an embodiment, the controller 120 may estimate the life of the battery cells 11 by inputting the first voltage, the second voltage, and the partial accumulative capacity to the estimation model. Herein, the life of the battery cells 11 may be an SOH value.

According to another embodiment, the controller 120 may input not only the first voltage, the second voltage, and the partial accumulative capacity, but also the temperature of the battery cells 11, to the regression model.

As described above, as the controller 120 charges and discharges the battery cells 11 in a partial voltage period, instead of charging/discharging the battery cells 11 in the entire voltage period, and inputs the thus obtained information to the estimation model to estimate the life of the battery cells 11, thereby the efficiency of capacity estimation of the battery cells 11 is improved. That is, by estimating the life using the estimation model, the controller 120 may perform charging/discharging only for the partial voltage period without performing charging/discharging for the entire voltage period of the battery cells 11, thereby obtaining the life of the battery cells 11. Accordingly, a time required for the controller 120 to obtain the life of the battery cells 11 may be reduced. Moreover, as the controller 120 charges and discharges the battery cells 11 only for the partial voltage period, the total amount of current supplied by the controller 120 may be reduced, thereby cutting down a cost for supply of the current.

As the controller 120 may adjust the first voltage and the second voltage, a process of setting an SOC of the battery cells 11 to 0 % or 100 % for charging/discharging in the entire voltage period of the battery cells 11 may not be required. Moreover, the controller 120 sets a charging/discharging period for the battery cells 11 based on a voltage in a state of a battery cell to which the voltage is applied, thus removing a need for a process of obtaining an open circuit voltage of the battery cells 11 to obtain the SOC value of the battery cells 11. Thus, an idle stage for obtaining the open circuit voltage of the battery cells 11 may be skipped, thereby reducing a time required for the controller 120 to charge/discharge the battery cells 11.

That is, as the controller 120 estimates the life of the battery cells 11 by using the estimation model, the efficiency of life estimation of the battery cells 11 may be improved.

The memory 130 may store the first voltage, the second voltage, the partial accumulative capacity, and the life of the battery cells 11. According to an embodiment, the memory 130 may transfer the first voltage, the second voltage, the partial accumulative capacity, and the life to the controller 120. According to an embodiment, the memory 130 may store the estimation model generated by the controller 120.

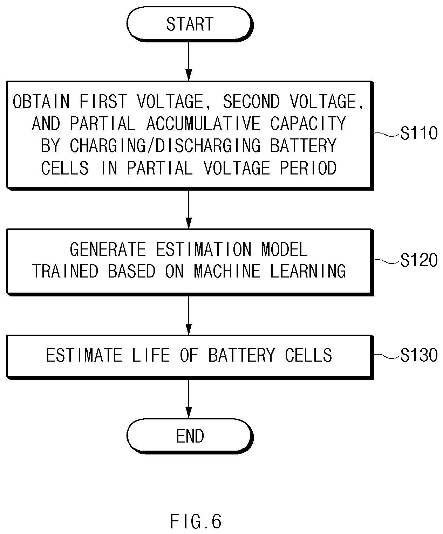

FIG. 6 is a flowchart of a battery life estimation method disclosed herein.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged.

Referring to FIG. 6, the battery life estimation method may include operation S110 of obtaining the first voltage, the second voltage, and the partial accumulative capacity by charging/discharging the battery cells in the partial voltage period, operation S120 of generating the estimation model trained based on machine learning, and operation S130 of estimating the life of the battery cells.

Hereinbelow, operations S110 through S130 will be described in detail with reference to FIGS. 1 to 5.

In operation S110, the battery life estimation apparatus 100 may charge/discharge the battery cells 11. The battery life estimation apparatus 100 may charge/discharge the battery cells 11 in a partial voltage period. Herein, the entire voltage period may be defined as a period from a third voltage defined as a voltage corresponding to a point at which a state of charge (SOC) of the battery cells 11 is 0 % to a fourth voltage defined as a voltage corresponding to a point at which the SOC of the battery is 100 %. The partial voltage period may be defined as a partial period of the entire voltage period of the battery cells 11. That is, the partial voltage period may be defined as a period from a first voltage to a second voltage, and the period from the first voltage to the second voltage may be included in the period from the third voltage to the fourth voltage.

The battery life estimation apparatus 100 may calculate the first voltage that is a start point of the partial period, the second voltage that is an end point of the partial period, and an accumulative capacity between the first voltage and the second voltage, by charging/discharging the battery cells 11 in the partial voltage period. That is, the first voltage may be defined as a voltage of a battery cell at a start point of the partial period. The second voltage may be defined as a voltage of a battery cell at an end point of the partial period.

According to an embodiment, the battery life estimation apparatus 100 may adjust a range of the partial voltage period to improve the accuracy of life estimation. For example, the battery life estimation apparatus 100 may set the partial voltage period to at least 50 % but less than 100 % of the entire voltage period.

The battery life estimation apparatus 100 may obtain a partial accumulative capacity between the first voltage and the second voltage by charging/discharging the battery cells 11 in the partial voltage period.

After operation S110, operation S120 may be performed.

In operation S120, the battery life estimation apparatus 100 may generate an estimation model trained based on machine learning. To this end, the battery life estimation apparatus 100 may train a plurality of regression models based on machine learning and select, as the estimation model, the most excellent one from among the plurality of regression models. That is, the estimation model may be one of the plurality of regression models.

The battery life estimation apparatus 100 may train each regression model based on the first voltage, the second voltage, and the partial accumulative capacity. That is, the battery life estimation apparatus 100 may supervised-train each regression model based on the first voltage, the second voltage, and the partial accumulative capacity, which are input values of the regression model, and the life of the battery cells 11, obtained by charging/discharging the battery cells 11 in the entire voltage period. As the battery life estimation apparatus 100 trains the regression model, the battery life estimation apparatus 100 may configure the regression model to output the life of the battery cells 11 by inputting the first voltage, the second voltage, and the partial accumulative capacity, which are input values, to the regression model. Herein, the plurality of regression models may include various models such as a random forest, XGBoost, etc.

Referring to FIGS. 4 and 5, the battery life estimation apparatus 100 may compare the life estimated using the regression model with the measured life. To this end, the battery life estimation apparatus 100 may estimate the life of the plurality of battery cells 11 using the regression model and measure the life of the plurality of battery cells 11. To this end, the battery life estimation apparatus 100 may control the charging/discharging unit 110 to charge/discharge the battery cells 11 at a second charging/discharging rate in the entire voltage period of the battery cells 11. According to an embodiment, the second charging/discharging rate may be different from the first charging/discharging rate. For example, the second charging/discharging rate may be 0.3 C-rate (C).

The battery life estimation apparatus 100 may generate a pair of a measurement life and an estimation life for each of the plurality of battery cells 11. The battery life estimation apparatus 100 may compare the estimated life with the measured life for each of the plurality of battery cells 11.

The battery life estimation apparatus 100 may generate a graph regarding the estimated life and the measured life for each regression model. According to an embodiment, the battery life estimation apparatus 100 may generate a graph having the measurement life as an X axis and the estimation life as a Y axis. The battery life estimation apparatus 100 may indicate the life of the plurality of battery cells 11 measured using the regression model on the graph. That is, the pair of the measurement life and the estimation life, generated by the battery life estimation apparatus 100, may be shown as one dot on the graph. The battery life estimation apparatus 100 may perform the same process for a sufficient number of battery cells 11 to indicate a sufficient number of pair of measurement lives and estimation lives in the graph.

The battery life estimation apparatus 100 may evaluate the performance of each regression model. According to an embodiment, the battery life estimation apparatus 100 may evaluate the regression model by using an evaluation indicator such as an MAE, an MSE, or an RMSE. In this way, the battery life estimation apparatus 100 may select the regression model having a superior evaluation indicator as the estimation model based on such performance evaluation.

According to an embodiment, the battery life estimation apparatus 100 may be calculate the MAE of the random forest model based on the graph of FIG. 4. The battery life estimation apparatus 100 may calculate the MAE of XGBoost based on the graph of FIG. 5. In this case, the MAE of the random forest, calculated by the battery life estimation apparatus 100, may be a value less than the MAE of XGBoost. A less value of the MAE may be closer to an ideal state, such that the battery life estimation apparatus 100 may select the random forest as an estimation model. While it is described that the battery life estimation apparatus 100 selects the estimation model based on the MAE, the present disclosure is not limited thereto. According to another embodiment, the battery life estimation apparatus 100 may select the estimation model based on the MSE or the RMSE.

After operation S120, operation S130 may be performed.

In operation S130, the battery life estimation apparatus 100 may estimate the life of the battery cells 11. The battery life estimation apparatus 100 may estimate the life of the battery cells 11 by inputting the first voltage, the second voltage, and the partial accumulative capacity to the estimation model. By estimating the life using the estimation model, the battery life estimation apparatus 100 may perform charging/discharging only for the partial voltage period without performing charging/discharging for the entire voltage period of the battery cells 11, thereby obtaining the life of the battery cells 11. Accordingly, a time required for the battery life estimation apparatus 100 to obtain the life of the battery cells 11 may be reduced. Moreover, as the battery life estimation apparatus 100 charges and discharges the battery cells 11 only for the partial voltage period, the total amount of current supplied by the battery life estimation apparatus 100 may be reduced, thereby cutting down a cost for supply of the current. That is, as the battery life estimation apparatus 100 estimates the life of the battery cells 11 by using the estimation model, the efficiency of life estimation of the battery cells 11 may be improved.

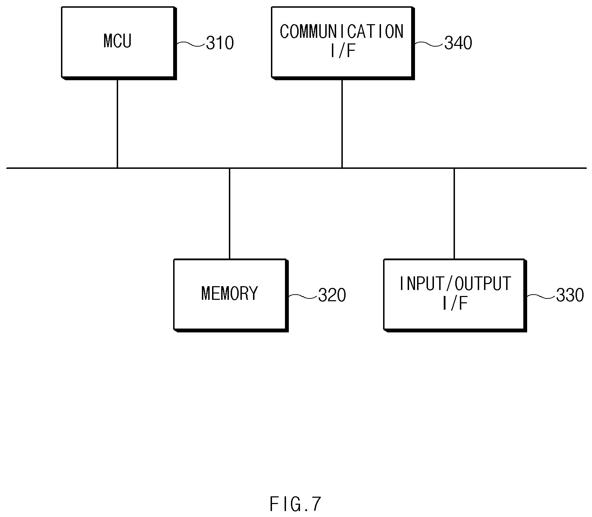

FIG. 7 illustrates a computing system that executes a battery life estimation method, according to an embodiment disclosed herein.

Referring to FIG. 7, a computing system 300 according to an embodiment disclosed herein may include an MCU 310, a memory 320, an input/output I/F 330, and a communication I/F 340.

The MCU 310 may be a processor that executes various programs (e.g., an SOH calculation program, a cell balancing target determination program, etc.) stored in the memory 320, processes various data including an SOC, an SOH, etc., of the plurality of battery cells 11 through these programs, and executes the above-described functions of the battery life estimation apparatus 100 described with reference to FIGS. 1 to 6.

The memory 320 may store various programs regarding SOH calculation of the battery cells 11, cell balancing target determination, etc. Moreover, the memory 320 may store various data such as SOC data, SOH data, etc., of each battery cell 11.

The memory 320 may be provided in plural, depending on a need. The memory 320 may include the volatile memory 130 or the non-volatile memory 130. For the memory 320 as the volatile memory 130, random access memory (RAM), dynamic RAM (DRAM), static RAM (SRAM), etc., may be used. For the memory 320 as the nonvolatile memory 130, read only memory (ROM), programmable ROM (PROM), electrically alterable ROM (EAROM), erasable PROM (EPROM), electrically erasable PROM (EEPROM), flash memory, etc., may be used. The above-listed examples of the memory 320 are merely examples and are not limited thereto.

The input/output I/F 330 may provide an interface for transmitting and receiving data by connecting an input device (not shown) such as a keyboard, a mouse, a touch panel, etc., and an output device such as a display (not shown), etc., to the MCU 310.

The communication I/F 340, which is a component capable of transmitting and receiving various data to and from a server, may be various devices capable of supporting wired or wireless communication. For example, a program for SOH calculation of the battery cells 11 or balancing target determination or various data, etc., may be transmitted and received to and from a separately provided external server through the communication I/F 340.

As such, the battery life estimation method according to an embodiment disclosed herein may be recorded in the memory 320 and executed by the MCU 310.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery life estimation apparatus comprising:
a charging/discharging unit configured to charge/discharge a battery; and
a controller configured to calculate a partial accumulative capacity corresponding to a partial voltage period defined as a period from a first voltage to a second voltage by charging/discharging the battery in the partial voltage period, and estimate a life corresponding to an entire voltage period of the battery by inputting the first voltage, the second voltage, and the partial accumulative capacity to an estimation model trained based on machine learning.

2. The battery life estimation apparatus of claim 1, wherein the entire voltage period is defined as a period from a third voltage defined as a voltage corresponding to a point at which a state of charge (SOC) of the battery is 0 % to a fourth voltage defined as a voltage corresponding to a point at which the SOC of the battery is 100 %.

3. The battery life estimation apparatus of claim 2, wherein a rate of the partial voltage period with respect to the entire voltage period is at least 50 % but less than 100 %.

4. The battery life estimation apparatus of claim 1, wherein the controller is further configured to control the charging/discharging unit to charge/discharge the battery at a first charging/discharging rate in the partial voltage period.

5. The battery life estimation apparatus of claim 4, wherein the first charging/discharging rate is 1C-rate (C).

6. The battery life estimation apparatus of claim 1, wherein the controller is further configured to train a first regression model and a second regression model, which is different from the first regression model, based on machine learning, and select, as the estimation model, a model having a less mean absolute error (MAE) between the first regression model and the second regression model.

7. The battery life estimation apparatus of claim 6, wherein the controller is further configured to obtain a measurement life corresponding to the entire voltage period of the battery by charging/discharging the battery in the entire voltage period, obtain an estimation life corresponding to the entire voltage period of the battery by inputting the first voltage, the second voltage, and the partial accumulative capacity to the first regression model, and obtain an MAE of the first regression model based on the measurement life and the estimation life.

8. The battery life estimation apparatus of claim 6, wherein the estimation model comprises a random forest model.

9. The battery life estimation apparatus of claim 6, wherein the controller is further configured to train each of the first regression model and the second regression model to output a life corresponding to the entire voltage period of the battery, when the first voltage, the second voltage, and the partial accumulative capacity are input.

10. The battery life estimation apparatus of claim 1, further comprising a memory storing the first voltage, the second voltage, the partial accumulative capacity, and the estimation model.

11. A battery life estimation method comprising:
calculating a partial accumulative capacity corresponding to a partial voltage period defined as a period from a first voltage to a second voltage by charging/discharging a battery in the partial voltage period;
generating an estimation model trained based on machine learning; and
estimating a life corresponding to an entire voltage period of the battery by inputting the first voltage, the second voltage, and the partial accumulative capacity to the estimation model.

12. The battery life estimation method of claim 11, wherein the generating of the estimation model comprises training a first regression model and a second regression model, which is different from the first regression model, based on machine learning, and select, as the estimation model, a model having a less mean absolute error (MAE) between the first regression model and the second regression model.

13. The battery life estimation method of claim 12, wherein the generating of the estimation model comprises obtaining a measurement life corresponding to the entire voltage period of the battery by charging/discharging the battery in the entire voltage period, obtain an estimation life corresponding to the entire voltage period of the battery by inputting the first voltage, the second voltage, and the partial accumulative capacity to the first regression model, and obtain an MAE of the first regression model based on the measurement life and the estimation life.

14. The battery life estimation method of claim 12, wherein the estimation model comprises a random forest model.

15. The battery life estimation method of claim 12, wherein the generating of the estimation model comprises training each of the first regression model and the second regression model to output a life corresponding to the entire voltage period, when the first voltage, the second voltage, and the partial accumulative capacity are input.

16. The battery life estimation method of claim 11, wherein the calculating of the partial accumulative capacity comprises charging/discharging the battery at a first charging/discharging rate in a period corresponding to the partial voltage period.

17. The battery life estimation method of claim 16, wherein the first charging/discharging rate is 1C-rate (C).
